(19) Europäisches Patentamt
European Patent Office
Office européen des brevets

(11) **EP 2 451 033 A1**

(12) **EUROPEAN PATENT APPLICATION**
published in accordance with Art. 153(4) EPC

(43) Date of publication:
**09.05.2012 Bulletin 2012/19**

(51) Int Cl.:
***H01S 5/14*** (2006.01)   ***H01S 5/06*** (2006.01)

(21) Application number: **09846682.4**

(22) Date of filing: **30.06.2009**

(86) International application number:
**PCT/CN2009/072560**

(87) International publication number:
**WO 2011/000153 (06.01.2011 Gazette 2011/01)**

(84) Designated Contracting States:
**AT BE BG CH CY CZ DE DK EE ES FI FR GB GR HR HU IE IS IT LI LT LU LV MC MK MT NL NO PL PT RO SE SI SK TR**

(71) Applicant: **Shandong Fareach Optics, Inc**
**Weifang, Shandong 261061 (CN)**

(72) Inventor: **ZHANG, Guangzhi**
**Weifang**
**Shandong 261061 (CN)**

(74) Representative: **Körber, Martin Hans**
**Mitscherlich & Partner**
**Sonnenstraße 33**
**80331 München (DE)**

(54) **CONTINUOUS MODE-HOP-FREE GRATING-TUNED EXTERNAL CAVITY SEMICONDUCTOR LASER**

(57)    The embodiments of the present invention disclose a GTECL, comprising at least one optical component constituted by a gain medium and a collimating lens, a tuning apparatus and at least one diffraction grating; wherein the gain medium is adapted to output a coherent light beam; the coherent light beam becomes parallel light after passing through the collimating lens; after the parallel light is diffracted by the diffraction grating, one part of diffraction light is directly taken as first output laser light, and the other part of diffraction light is returned to the gain medium along with an original incident light path, and is taken as second output laser light when exceeding an oscillation threshold of the laser through being oscillated and amplified in the gain medium; the diffraction grating is configured on the tuning apparatus; the tuning apparatus is adapted to drive the diffraction grating to rotate on a rotation axis located on a back surface of the diffraction grating; and the rotation axis is parallel with a diffraction surface of the diffraction grating and is vertical to an optical axis of the laser. By using the laser, the continuous mod-hop-free tuning of laser frequency can be implemented, and the manufacturing costs of the laser can be decreased.

Figure 4

**Description**

**Field of the Invention**

The present invention relates to laser technologies, more particularly to a continuous mod-hop-free Grating-Tuned External Cavity Laser (GTECL).

**Background of the Invention**

Wavelength tuning technology of light sources is an important part of laser technologies, Grating-Tuned External Cavity Lasers (GTECL) have been widely applied to multiple fields such as optical communications, optical switch, optical storage, optical fiber gyroscope, measurement, spectral measurement with high resolution and biomedicine, because of their outstanding merits such as high spectral purity, a wide wavelength coverage range, a compact structure, a high translation efficiency, single-mode output, lost costs and high reliability, GTECL have a good application prospect.

In the prior art, there are usually two types of GTECLs. One is a Littrow type, and the other is a Littman-Metcalf type. The two types of lasers will be respectively described hereinafter.

The GTECL of the Littrow type can generate a frequency-tuned laser beam with very narrow line width and very high optical coherence, and has a resonant cavity with a compact structure and a simple shape in practical products. The resonant cavity usually includes only three optical devices, i.e. a laser as a laser gain medium, a diffraction grating as a frequency selective component and a collimating lens for collimating a laser beam, and thus a simplified and lost-cost manufacture process can be implemented. For example, a GTECL put forward by Wieman and Hollberg is a typical GTECL of the Littrow type, referring to the document "'using Diode Lasers for Atomic Physics' by Carl E. Wieman and Leo Hollberg, Review of Scientific Instruments, Vol. 62, Pages 1-19, January, 1991".

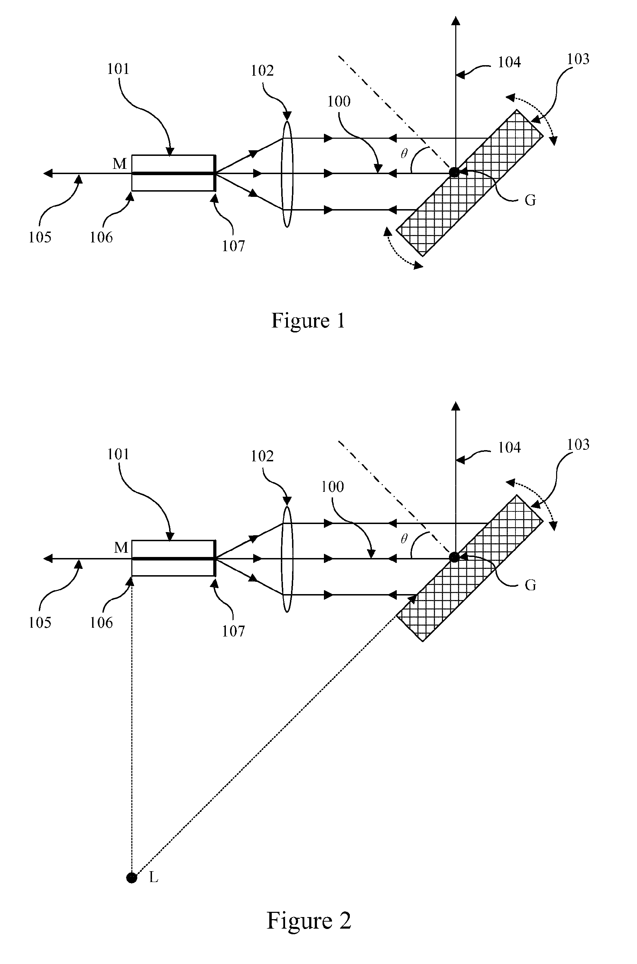

Figure 1 is a schematic diagram illustrating a GTECL of the Littrow type in the prior art. As show in Figure 1, the GTECL includes a laser 101, a collimating lens 102 and a diffraction grating 103. The laser 101 includes a back surface 106 and a front surface 107. Parallel light is obtained after a light beam generated by the laser 101 passes through the collimating lens 102. The parallel light is diffracted by the diffraction grating 103 after the incidence of the parallel light to the diffraction grating 103. Zero-level diffraction light can be output directly as output laser light 104, and first-level diffraction light returns to the laser 101 along with an original incidence light path, and is oscillated and amplified in the laser 101, and then is output as output laser light 105, so as to output Single Longitudinal Mode (SLM) laser light with narrow line width.

In the above GTECL, the diffraction grating 103 may rotate on a fixed rotation axis passing through a G point and being vertical to a paper surface. The G point is an intersecting point of an optical axis 100 and the surface of the diffraction grating 103. When the diffraction grating 103 rotates on the fixed rotation axis, the frequency tuning and wavelength tuning of the output laser light can be implemented. However, when continuous tuning is performed according to the design of the above resonant cavity, the single longitudinal mode of the laser may suddenly hop from one longitudinal mode to another longitudinal mode, so as to cause a mod hopping phenomenon. Because of the mod hopping phenomenon, frequency hopping equivalent to a longitudinal mode interval of the laser is generated on a laser output frequency, and thus the continuous tuning of the laser output frequency is destroyed, thereby resulting in a bad influence on the accuracy of frequency tuning, the linearity of frequency tuning and other applications depending on characteristics of frequency tuning. Therefore, the mod hopping phenomenon should be avoided as much as possible, and it is required to implement continuous mod-hop-free (MHF) frequency tuning or wavelength tuning.

The above mod hopping phenomenon may be described according to the following formulas.

From a grating equation:

$$\lambda(\theta) = 2d_g \cdot \sin\theta \qquad (1.1)$$

and a resonance condition:

$$N \cdot \frac{\lambda}{2} = L_{MG} \qquad (1.2),$$

as can be seen,

$$N = \frac{L_{MG}}{d_g \cdot \sin \theta} \qquad (1.3).$$

Herein, N represents a modulus of the $N^{th}$ longitudinal mode in the resonant cavity, and N is an integer; $\lambda(\theta)$ represents oscillation wavelength of laser light, i.e. the wavelength of laser light selected through grating dispersion, and the wavelength of the laser light relates to $\theta$, i.e. $\lambda(\theta)$ changes with $\theta$, $L_{MG}$ represents an optical distance from an M point (i.e. an intersecting point of the optical axis 100 and the back surface 106 of the laser 101) to the G point, i.e. the optical length of the external cavity (called as external cavity length for short); dg represents grooving density of the diffraction grating 103; $\theta$ represents an incident angle of a laser beam to the diffraction grating 103, also called as a diffraction angle.

As can be seen from Figure 1, $L_{MG}$ and dg are usually constants. When the diffraction grating 103 rotates on the fixed rotation axis, the diffraction angle $\theta$ will change. As can be seen from the formula (1.2), the laser frequency or laser wavelength output by the laser will change. As can be seen from the formula (1.3), when the diffraction angle $\theta$ changes, the modulus N will change, i.e. the modulus N is not a constant when the diffraction angle B changes, and thus when the diffraction angle $\theta$ changes in a large range, the mod hopping phenomenon will occur, i.e. the modulus N plus 1 or minus 1 will occur. That is, when the laser shown in Figure 1 tunes the laser frequency or laser wavelength by rotating the diffraction grating, i.e. changes the frequency of the output laser light, the mod hopping phenomenon will occur. Therefore, the above GTECL of the Littrow type can only implement very little or limited MHF tuning, but can not perform continuous MHF tuning for the laser frequency or laser wavelength.

In the prior art, there is another GTECL of the Littrow type, e.g. a GTECL disclosed in US Patent No. 6,731,661 by Trutna Jr. Figure 2 is a schematic diagram illustrating a GTECL of the Littrow type in the prior art. As shown in Figure 2, the GTECL also includes the laser 101, the collimating lens 102 and the diffraction grating 103. Different from the GTECL shown in Figure 1, the rotation axis of the diffraction grating 103 shown in Figure 2 is L, the rotation axis L is located at an intersecting point of an extension line of the diffraction surface of the diffraction grating 103 and an extension line of the back surface 106 of the laser 101, and the rotation axis L is vertical to the paper surface. When the diffraction grating 103 rotates on the fixed rotation axis L, the frequency tuning and wavelength tuning of the output laser light can be implemented.

Similarly, according to the grating equation:

$$\lambda(\theta) = 2d_g \cdot \sin \theta \qquad (2.1)$$

and the resonance condition:

$$N \cdot \frac{\lambda}{2} = L_{MG}(\theta) \qquad (2.2),$$

and if optical components in the resonant cavity are all in an idea state, then

$$L_{MG}(\theta) = \overline{OM} \cdot \tan \theta \qquad (2.3).$$

As can be seen,

$$N = \frac{\overline{OM}}{d_g \cdot \cos \theta} \qquad (2.4).$$

Herein, $L_{MG}(\theta)$ represents a distance from an M point on the back surface 106 of the laser 101 to the center of the surface of the diffraction grating 103, i.e. the length of the external cavity. The length of the external cavity relates to θ, in other words, $L_{MG}$ (θ) changes with θ. OM represents a distance from the rotation axis L to the M point on the back surface 106 of the laser 101.

As can be seen from the formula (2.4), when $\overline{OM}$ and $dg$ are unchanged, if the diffraction angle θ changes by rotating the diffraction grating 103, the modulus N will change, i.e. the modulus N is not a constant when the diffraction angel θ changes. When the diffraction angel θ changes in a large range, the mod hopping phenomenon will occur, i.e. the modulus N plus 1 or minus 1 will occur. Therefore, comparing with the GTECL shown in Figure 1, the GTECL shown in Figure 2 has a wider MHF tuning range, but its modulus N still depends on the diffraction angle θ. And thus, when the diffraction angel θ changes in a lager range, it is impossible to guarantee that N is a constant. Therefore, in the GTECL shown in Figure 2, the continuous MHF tuning of the laser frequency can not be implemented.

In order to solve the above problems, in the prior art, a broadband MHF-tuned GTECL is manufactured by using a Littman-Metcalf resonant cavity structure, i.e. a GTECL of the Littman-Metcalf type. The resonant cavity structure of the laser of the Littman-Metcalf type has been disclosed by multiple documents and patents, e.g. US Patent No. 5,319,668 of Luecke, US Patent No.5,867,512 of Sacher, US Patent No.5,771,252 of Lang, US Patents No.5,802,085, No.6,606,340, No.6,608,847, No.6,788,726 and No.6,940,879 of Zhang, US Patent No.7,388,890 of Le, and so on.

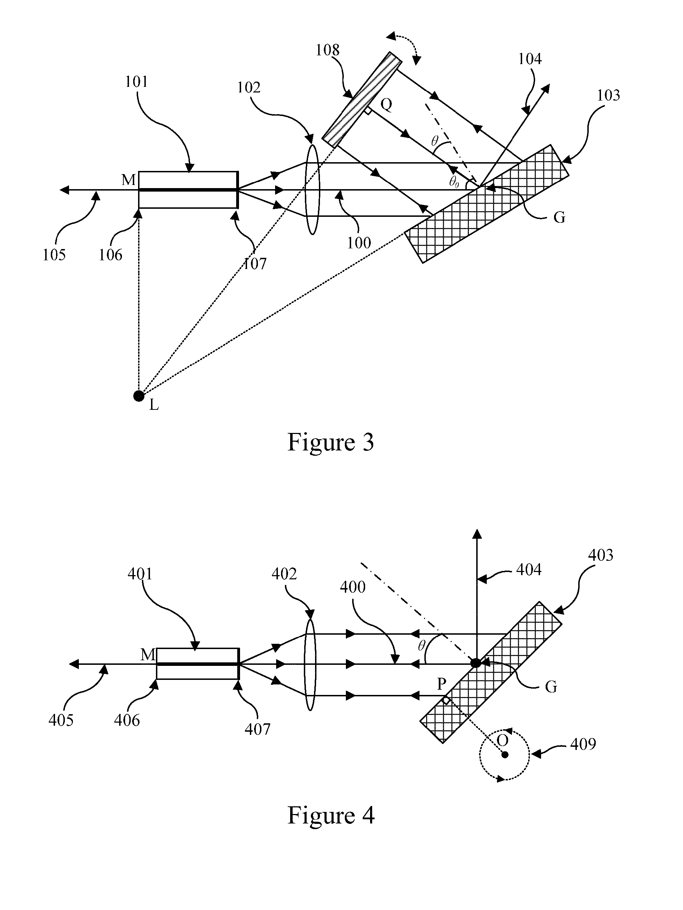

Figure 3 is a schematic diagram illustrating a GTECL of the Littman-Metcalf type in the prior art. As shown in Figure 3, the GTECL of the Littman-Metcalf type includes a plane reflector 108 besides the laser 101, the collimating lens 102 and the diffraction grating 103. The rotation axis L is located at an intersecting point of the extension line of the back surface 106 of the laser 101, the extension line of the diffraction surface of the diffraction grating 103 and the extension line of the reflection surface of the plane reflector 108, and is vertical to the paper surface. The Q point is an intersecting point of reflection light passing through the G point and the plane reflector 108. In the GTECL, the diffraction grating 103 is fixed, and the plane reflector 108 may rotate on the fixed rotation axis L. When the plane reflector 108 rotates on the fixed rotation axis L, the diffraction angle θ changes, and the length of the external cavity (i.e. the sum of a distance between the M point and the G point and a light path between the G point and the Q point) also changes. When the rotation axis L is located at a proper location, the modulus N may be a constant, and thus the modulus N may keep unchanged when the laser frequency changes, so as to implement the continuous mod-hop-free tuning for the laser frequency.

As can be seen from the principle, it is supposed that the GTECL shown in Figure 3 is in an ideal working state, e.g. optical components in the resonant cavity of the GTECL have no dispersion or can be aligned to corresponding locations, the GTECL of the Littman-Metcalf type can have the largest MHF tuning range which covers a whole spectrum range generated by the diffraction grating. However, due to the limitation of industry manufacture technologies and assembly debugging measurement, an actual GTECL shown in Figure 3 usually has such a problem that optical components have dispersion and can not be aligned to corresponding locations, so as to limit the MHF tuning range of the GTECL.

In order to overcome the above problem, Zhang and Hakuta provide a resonant cavity structure in which the locations of optical components can be automatically adjusted and passively compensated, so as to implement the broadband MHF tuning. However, during the manufacture process of the laser, there are various problems such as complex optical and mechanical alignment, extra material costs of the optical components, ultra-large size of the cavity and a slow tuning speed.

Therefore, all the GTECLs in the prior art have the above problems, thereby limiting their applications in various fields. And thus, it is required to provide a continuous mod-hop-free GTECL which can be manufactured with low costs and in batch production, and has a high stability and a compact structure, to implement continuous mod-hop-free tuning of the laser frequency.

**Summary of the Invention**

Embodiments of the present invention provide a continuous mod-hop-free grating-tuned external cavity laser, so as to implement continuous mod-hop-free tuning of laser frequency and decrease the manufacturing costs of the laser.

The technical solution of the embodiments of the present invention is as follows.

A continuous mod-hop-free grating-tuned external cavity laser includes: at least one optical component constituted by a gain medium and a collimating lens, a tuning apparatus and at least one diffraction grating; wherein the gain medium is adapted to output a coherent light beam; the coherent light beam becomes parallel light after passing through the collimating lens; after the parallel light is diffracted by the diffraction grating, one part of diffraction light is directly taken as first output laser light, and the other part of diffraction light is returned to the gain medium along with an original incident light path, and is taken as second output laser light when exceeding an oscillation threshold of the laser through being oscillated and amplified in the gain medium;

the diffraction grating is configured on the tuning apparatus; the tuning apparatus is adapted to drive the diffraction grating to rotate on a rotation axis located on a back surface of the diffraction grating; and the rotation axis is parallel with a diffraction surface of the diffraction grating and is vertical to an optical axis of the laser.

A location of the rotation axis is preconfigured to meet a condition that during a process of tuning output laser frequency of the laser, modulus of a longitudinal mode selected by a resonant cavity of the laser is a constant.

A rotation radius of the diffraction grating is a vertical distance from the ration axis to the diffraction surface of the diffraction grating.

The tuning apparatus is further adapted to change a location of the rotation axis in real time, or change a relative location between the rotation axis and the diffraction grating in real time.

The tuning apparatus includes: a driving apparatus and a rotation base; the rotation base is connected with the driving apparatus;

the rotation base is adapted to support or install the diffraction grating;

the driving apparatus is adapted to drive the rotation base to make the diffraction grating rotate on the rotation axis, and change the location of the rotation axis in real time, or change the relative location between the rotation axis and the diffraction grating in real time.

The driving apparatus is a rotation motor, a stepper engine, or a micro electronic mechanic system.

The tuning apparatus further includes a control apparatus and an encoder;

the encoder is adapted to trace movement of the rotation base, and send a tracing result to the control apparatus;

the control apparatus is adapted to selectively control movement of the rotation base according to the tracing result and selected wavelength of the output laser light, to perform continuous mod-hop-free tuning for output laser frequency of the laser.

The laser comprises multiple diffraction gratings;

the multiple diffraction gratings are configured on the tuning apparatus; the tuning apparatus is adapted to drive the multiple diffraction gratings to rotate on the same rotation axis; the rotation axis is parallel with diffraction surfaces of the diffraction gratings and vertical to an optical axis of the laser;

the optical component is adapted to perform continuous mod-hop-free tuning for output laser frequency by using any diffraction grating configured on the tuning apparatus.

The laser further comprises a partial reflector configured on a light path between the collimating lens and the diffraction grating;

the partial reflector is adapted to generate third output laser light and fourth output laser light without a spectrum noise.

The partial reflector is a spectroscope, a space filter slice or a coupling fiber.

The laser further includes a coupling apparatus;

the coupling apparatus is adapted to couple at least one beam of the output laser light of the laser to a needed single mode or multimode fiber.

The laser further comprises one or more sets of optical components;

each set of the optical components is adapted to perform continuous mod-hop-free tuning for output laser frequency by using any one of the diffraction gratings configured on the tuning apparatus.

As can be seen, the embodiments of the present invention provide a continuous mod-hop-free grating-tuned external cavity laser. The continuous mod-hop-free grating-tuned external cavity laser includes a tuning apparatus and at least one diffraction grating, and the diffraction grating is configured on the tuning apparatus; the tuning apparatus is adapted to drive the diffraction grating to rotate on a preconfigured rotation axis located on the back surface of the diffraction grating, and the rotation axis is parallel with the diffraction surface of the diffraction grating and is vertical to the optical axis of the laser, and thus the continuous mod-hop-free tuning of laser frequency can be implemented and the manufacturing costs of the laser can be decreased.

## Brief Description of the Drawings

Figure 1 is a schematic diagram illustrating a GTECL of the Littrow type in the prior art.

Figure 2 is a schematic diagram illustrating another GTECL of the Littrow type in the prior art.

Figure 3 is a schematic diagram illustrating a GTECL of the Littman-Metcalf type in the prior art.

Figure 4 is a schematic diagram illustrating a GTECL according to a first embodiment of the present invention.

Figure 5 is a schematic diagram illustrating a principle of the GTECL according to the first embodiment of the present invention.

Figure 6 is a schematic diagram illustrating a GTECL according to a second embodiment of the present invention.

Figure 7 is a schematic diagram illustrating a GTECL according to a third embodiment of the present invention.

Figure 8 is a schematic diagram illustrating a GTECL according to a fourth embodiment of the present invention.

**Detailed Description of the Invention**

The specific implementation of the present invention will be described hereinafter in detail with reference to the accompany drawings and embodiments.

Figure 4 is a schematic diagram illustrating a GTECL according to a first embodiment of the present invention. As shown in Figure 4, the GTECL in the embodiment includes: a gain medium 401, a collimating lens 402 and a diffraction grating 403. The gain medium 401 and the collimating lens 402 constitute an optical component. The gain medium 401 is adapted to generate a stable light gain and output a coherent light beam. For example, the gain medium 401 may include a back surface 406 of total reflection or partial reflection, a front output surface 407 covered with an anti-reflection coat and a laser chip which may be a common laser chip of the Fabry-Pero type or a component having similar functions. The M point in Figure 4 is an intersecting point of the optical axis 400 and the back surface 406 of the gain medium 401, and the G point is an intersecting point of the optical axis 400 and the diffraction grating 403. Therefore, the external resonant cavity (called an external cavity for short) of the laser is restricted by the back surface 406 of the gain medium 401 and the diffraction grating 403. The gain medium 401 outputs a coherent light beam through the front output surface 407, the coherent light beam becomes parallel light after passing through the collimating lens 402, and the parallel light is diffracted after the incidence to the diffraction grating 403. After the parallel light is diffracted by the diffraction grating 403, one part of diffraction light (e.g. zero-level diffraction light) may be directly taken as first output laser light (e.g. output laser light 404), the other part of the diffraction light (e.g. first-level diffraction light or higher-level diffraction light) is returned to the back surface 406 of the gain medium 401 along with the original incident light path, and then the back surface 406 reflects the returned light to the diffraction grating 403; the rest may be deduced by analogy, until the diffraction light exceeds an oscillation threshold of the laser after being oscillated and amplified in the gain medium 401, the diffraction light may be taken as second output laser light (e.g. output laser light 405). As can be seen, the length of the external cavity in the resonant cavity of the laser is the total sum of light paths between the M point and the G point.

In order to implement the continuous mod-hop-free tuning of the laser frequency, in the technical solution of embodiments of the present invention, the laser shown in Figure 4 further includes a tuning apparatus 409, and the tuning apparatus 409 and the diffraction grating 403 constitute a tuning component. The diffraction grating 403 is configured on the tuning apparatus 409, and the tuning apparatus 409 is adapted to drive the diffraction grating 403 to rotate on a preconfigured rotation axis located on the back surface of the diffraction grating 403. The rotation axis is parallel with the diffraction surface of the diffraction grating 403 and is vertical to the optical axis 400 of the laser, i.e. the rotation axis passes through the O point and is vertical to the paper surface; in other words, the rotation axis is not on the extension line of the diffraction surface of the diffraction grating 403, but behind the back surface of the diffraction grating 403. In addition, the tuning apparatus 409 is also adapted to change the location of the O point in real time, i.e. change the location of the rotation axis in real time, or change the relative location between the O point and the diffraction grating 403 in real time, i.e. change the relative location between the rotation axis and the diffraction grating 403 in real time. A rotation radius of the diffraction grating 403 is the vertical distance from the O point (i.e. the rotation axis) to the diffraction surface of the diffraction grating 403, which is represented by $\overline{OP}$. Here, the P point is an intersecting point of a perpendicular from the O point to the diffraction surface of the diffraction grating 403 and the diffraction surface of the diffraction grating 403.

In the embodiment of the present invention, when the diffraction grating 403 rotates on the rotation axis, the rotation axis is not on the extension line of the diffraction surface of the diffraction grating 403, but behind the back surface of the diffraction grating 403, the location of the rotation axis and/or the relative location between the rotation axis and the diffraction grating 403 can be configured in advance or in real time, and thus the GTECL can be designed flexibly according to the tuning requirements of the laser frequency, and can implement the MHF tuning in which the modulus N of the longitudinal mode selected by the resonant cavity of the laser is a constant. Therefore, the continuous mod-hop-free tuning of laser frequency can be implemented without needing other extra control modes or measurements, and the largest MHF tuning range covering the whole spectrum range generated by the diffraction grating can be obtained, so as to simply the resonant cavity structure of the laser and decrease the manufacturing costs of the laser. The principle for implementing the continuous mod-hop-free tuning will be described hereinafter in detail.

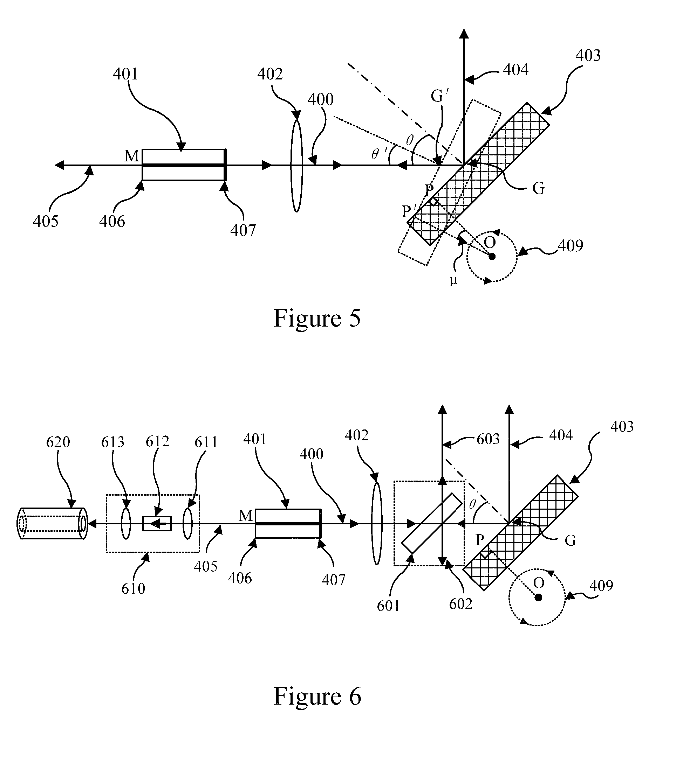

Figure 5 is a schematic diagram illustrating the principle of the GTECL according to the first embodiment of the present invention. As shown in Figure 5, when the diffraction grating 403 rotates an angle μ around the rotation axis passing through the O point, the location of the diffraction grating 403 changes, and thus the diffraction angle changes from θ to θ', the G point moves to a G' point, i.e. the diffraction angle of the laser and the length of the external cavity of the laser all change, so as to implement the tuning of laser frequency by using the above change.

When the diffraction grating 403 is in an initial state and does not rotate, the diffraction angle is θ; suppose the grooving density of the diffraction grating 403 is dg, it is can be seen according to the resonance condition that the center wavelength of the laser light selected through the diffraction grating 403 is:

$$\lambda(\theta) = 2d_g \cdot \sin \theta \qquad (4.1).$$

As shown in Figure 5, when the diffraction angle is θ, the length of the external cavity of the laser is the total sum $L_{light}(\theta)$ of the light paths between the M point and the G point, and it can be seen according to the grating equation that:

$$N(\theta) \cdot \frac{\lambda(\theta)}{2} = L_{light}(\theta) \qquad (4.2).$$

Here, $N(\theta)$ represents the modulus of the $N^{th}$ longitudinal mode in the resonant cavity of the GTECL when the diffraction angle is θ, and $N(\theta)$ is an integer.

After the tuning apparatus 409 drives the diffraction grating 403 to rotate an angle around the rotation axis passing through the O point, e.g. the diffraction angle changes to θ', the G point on the diffraction surface of the diffraction grating 403 changes to the G' point; at this time, the length of the external cavity of the laser is the total sum $L_{ligh'}(\theta)$ of the light paths between the M point and the G' point, i.e. the length of the external cavity of the laser changes as:

$$L_{light}(\theta') = L_{light}(\theta) - \overline{GG'}(\theta', \theta) \qquad (4.3).$$

Here, $\overline{GG'}(\theta', \theta)$ represents the variable quantity of the length of the external cavity of the laser.

It can be seen according to the light paths shown in Figure 5 that

$$\overline{GG'}(\theta', \theta) = r_0 \cdot \frac{1 - \cos(\theta - \theta')}{\cos(\theta')} + t_0 \cdot \frac{\sin(\theta - \theta')}{\cos(\theta')} \qquad (4.4).$$

Here, $r_0 = \overline{OP} = \overline{OP'}$ and $t_0 = \overline{GP}$. $\overline{OP}$, $\overline{OP'}$ and $\overline{GP}$ respectively represent a distance from the O point to the P point, a distance from the P' point to the G point, and a distance from the G point to the P point. As can be seen from Figure 5, $r_0$ and $t_0$ are parameters having a determined relation with the location of the O point. After the location of the O point is determined, or the relative location between the O point and the diffraction grating 403 is determined, the values of $r_0$ and $t_0$ are determined. On the contrary, the location of the O point or the relative location between the O point and the diffraction grating 403 may be determined according to the values of $r_0$ and to.

When the diffraction angle is θ', suppose that $N(\theta')$ represents the modulus of the $N^{th}$ longitudinal mode in the resonant cavity of the GTECL and is an integer, $\lambda(\theta')$ is the center wavelength of the laser light selected through the diffraction grating 403; at this time,

$$\lambda(\theta') = 2d_g \cdot \sin \theta' \quad , \quad N(\theta') \cdot \frac{\lambda(\theta')}{2} = L_{light}(\theta') \qquad (4.5).$$

It can be seen according to the above formulas (4.1) ~ (4.5) that:

$$\frac{N(\theta')}{N(\theta)} = \frac{\sin(\theta)}{\sin(\theta')}\left[1 - \alpha_1 \cdot \frac{1-\cos(\theta-\theta')}{\cos(\theta')} - \alpha_2 \cdot \frac{\sin(\theta-\theta')}{\cos(\theta')}\right] \qquad (4.6).$$

Here, $\alpha_1 = r_0/L_{light}(\theta)$ and $\alpha_2 = t_0 / L_{light}(\theta)$. $\alpha_1$ and $\alpha_2$ represents that the modulus of the $N^{th}$ longitudinal mode in the resonant cavity of the laser can be adjusted by changing the location $r_0$ and $t_0$ of the rotation axis or by changing the relative location between the rotation axis and the diffraction grating.

It can be seen from the formula (4.6) that, in order to implement the continuous MHF tuning of all laser frequency, during the tuning of laser frequency, it is required that the modulus $N(\theta)'$ of the longitudinal mode selected by the resonant cavity is a constant, i.e. a continuous mod-hop-free tuning condition needs to be met:

$$N(\theta')/N(\theta) = 1, \text{ or } \left|N(\theta') - N(\theta)\right| \leq 1 \qquad (4.7)$$

When the laser is applied to actual environments, since gain bandwidth of the gain medium 11 is finite, it can be guaranteed that the continuous mod-hop-free tuning is performed in a frequency range given in the above finite gain bandwidth as long as the above continuous mod-hop-free tuning condition is met. As can be seen from the formula (4.6), it is only needed to adjust $r_0$ and $t_0$ in the formula (4.6), the continuous mod-hop-free tuning condition can be met easily, so as to implement the continuous MHF tuning of all laser frequency easily.

Since the change of the location of the diffraction grating 403 and/or the change of the location of the rotation axis (i.e. the change of the location of the O point) will result in the change of the values of $r_0$ and to, in the technical solution of the embodiments of the present invention, the values of the above two coordinates $r_0$ and $t_0$ may be changed by adjusting the location of the O point (i.e. the location of the rotation axis) in real time through an external feedback control mode, or by adjusting the absolute location or relative location between the diffraction grating 403 and the O point in real time, so as to make the continuous mod-hop-free tuning condition can be met in a larger frequency tuning range.

As can be seen from Figure 5, after the location of the O point or the relative location between the O point and the diffraction grating 403 is determined, the values of $r_0$ and to are determined. Therefore, in the technical solution of the embodiments of the present invention, the location of the O point or the relative location between the O point and the diffraction grating 403 may be determined in advance or in real time according to actual applications, so that the resonant cavity of the laser in which the diffraction grating 403 is located has proper length to output laser light with needed frequency when the diffraction grating 403 rotates on the rotation axis passing through the O point and being vertical to the paper surface, and thus the continuous mod-hop-free tuning of output laser frequency is implemented.

In the technical solution of the present invention, the tuning apparatus 409 may be used to determine the location of the O point or the relative location between the O point and the diffraction grating 403, and implement the rotation of the diffraction grating 403. The tuning apparatus 409 may be a fixed or dynamic location adjusting apparatus commonly used in the art. For example, in the embodiments of the present invention, the tuning apparatus 409 may include a driving apparatus and a rotation base (not shown in Figures 4 and 5). The diffraction grating 403 is configured on the rotation base. The rotation base is connected with the driving apparatus, and is adapted to support or install the diffraction grating 403, and change the location of the diffraction grating 403 according to the driving of the driving apparatus. The driving apparatus is adapted to drive the rotation base to make the diffraction grating 403 rotate on the rotation axis, and is also adapted to change the location of the O point or the relative location between the O point and the diffraction grating 403, so as to make the diffraction grating 403 rotate on the rotation axis passing through the O point and being vertical to the paper surface to reach a needed location. The driving apparatus may be a rotation engine, a stepper motor, or a Micro Electronic Mechanic System (MEMS), or other devices which can implement the driving. The driving apparatus may be connected with the rotation base by using a direct fixing mode, (e.g. a rotation bearing of the rotation engine or stepper motor is connected with the rotation base fixedly, or is connected with the rotation base fixedly through a universal joint; the connection mode of the rotation bearing can guarantee that the rotation base rotates on the rotation axis passing through the O point and being vertical to the paper surface), or through other connection modes commonly used in the art, which will not be descried herein.

In addition, the tuning apparatus 409 may further include a control apparatus and an encoder, e.g. a linearity encoder or a motor rotation encoder, (not shown in Figures 4 and 5). The encoder is adapted to trace the movement of the rotation base, and send a tracing result to the control apparatus. The movement of the rotation base may be translation, rotation or translation plus rotation. The translation of the rotation base may change the location of the rotation axis or the relative location between the rotation axis and the diffraction grating; the rotation of the rotation base may make the diffraction grating on the rotation base rotate on the rotation axis. The control apparatus is adapted to selectively control the movement of the rotation according to the selected wavelength of the output laser light and the tracing result, so as to perform continuous mod-hop-free tuning for the output laser frequency when outputting the laser light with the needed frequency. As can be seen, by using the tuning apparatus 409, the continuous mod-hop-free tuning of the output laser frequency can be implemented when the laser light with the needed frequency is output.

In the GTECL shown in Figure 5, the following can be taken as the output laser light: 1) output laser light 404, which is laser light output directly after being reflected by the diffraction surface of the diffraction grating 403; 2) output laser light 405, which is output from the back surface 406 of the gain medium 401 after being reflected by the diffraction surface of the diffraction grating 403 to the gain medium 401 and being oscillated and amplified in the gain medium 401.

However, in the output laser light 404 and the output laser light 405, there is still a higher spectrum noise, which is light source spontaneous emission (SSE) and amplified spontaneous emission (ASE) coming from the gain medium 401. The spectrum noise has a bad influence on the coherence and intensity of the output laser light. Therefore, in the technical solution of the embodiments of the present invention, a partial reflector may be further configured in the GTECL shown in Figure 5, and is adapted to eliminate the spectrum noise in the output laser light (i.e. the ASE and SSE in the output laser light).

Figure 6 is a schematic diagram illustrating a GTECL according to a second embodiment of the present invention. As shown in Figure 6, the GTECL in the embodiment further includes a partial reflector 601 configured on a light path between the collimating lens 402 and the diffraction grating 403 except the gain medium 401, the collimating lens 402, the diffraction grating 403 and the tuning apparatus 409. The partial reflector 601 may be configured as or rotate to any needed angle according to actual requirements, to eliminate the spectrum noise in the output laser light. Preferably, the partial reflector 601 may be a spectroscope or other types of space filter slices. Since the wavelength of the spectrum noise is different from the wavelength of the output laser light, in space distribution, the spectrum noise may be departed or deviated from the light path of the output laser light through the diffraction of the diffraction grating 403. And thus, the spectrum noise in the output laser light can be completely eliminated by configuring the partial reflector (e.g. a reflector, a space filter slice or a coupling fiber).

In the embodiment of the present invention, the partial reflector 601 may divide the laser light passing through the partial reflector 601 into two beams of laser light and output the two beams of laser light. One beam of the laser light is output laser light 602, which does not contain the spectrum noise (i.e. does not contain the ASE and SSE) because of the elimination function of the partial reflector 601; the other beam of the laser light is output laser light 603, which is a conventional tunable laser beam, contains the spectrum noise (i.e. contains the ASE and SSE), and is opposite to the output laser light 602.

By using the GTECL shown in Figure 6, the conventional tunable laser beam can be obtained (e.g. the output laser light 404, 405 and 603), further the laser beam (e.g. the output laser light 602) which has high coherence and high spectrum purity and from which the spectrum noise is eliminated can be obtained, so as to improve the performance of the GTECL and effectively extend the application scope of the GTECL.

In the embodiment of the present, in order to couple the continuous mod-hop-free tuning laser light generated by the GTECL and a corresponding single-mode or multi-mode fiber 620, the GTECL may further include a coupling apparatus 610 shown in Figure 6, which may be adapted to couple the output laser light of the laser to the needed single-mode or multi-mode fiber 620. Hereinafter, the technical solution of the present invention will be described by taking the output laser light 405 as an example.

The coupling apparatus 610 includes a light beam collecting apparatus 611, a light isolator 612 and a calibration lens 613. The light beam collecting apparatus 611 is adapted to collect the output laser light 405 output from the back surface 406 of the gain medium 401, and output the collected output laser light to the light isolator 612. The light isolator 612 is adapted to prevent the interference of external feedback light, and unidirectionally output the output laser light. The calibration lens 613 is adapted to calibrate the laser light output from the light isolator 612, to make the output laser light become a parallel laser beam; or focalize the laser light output from the light isolator 612, to make the output laser light be coupled to the corresponding fiber 620.

In addition, the coupling apparatus 610 may be used in the direction of the output laser light 404, 603 and 602 of the GTECL respectively, so as to couple the output laser light to the needed fiber.

In the technical solution of the present invention, the tuning component in the GTECL may be further improved, to improve the sweeping rate and tuning speed of the GTECL.

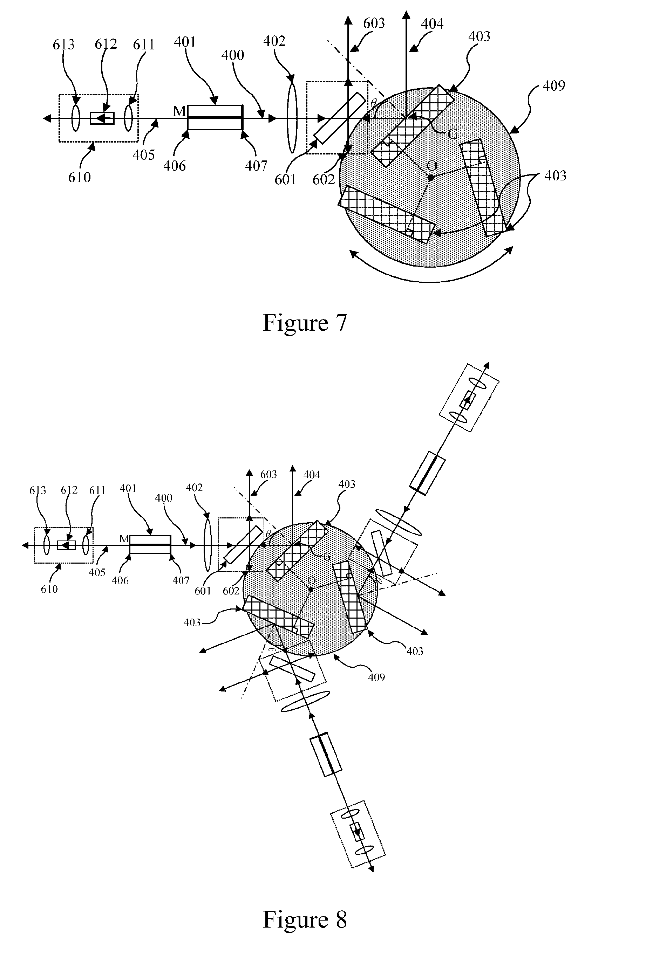

Figure 7 is a schematic diagram illustrating a GTECL according to a third embodiment of the present invention. As shown in Figure 7, the GTECL of the present invention includes a gain medium 401, a collimating lens 402, a tuning apparatus 409, a partial reflector 601, a coupling apparatus 610 and at least one diffraction grating 403. In the embodiment of the present invention, the GTECL may include one or more diffraction gratings 403. In order to better describe the technical solution of the present invention, the technical solution is described by taking an example in which the GTECL includes three diffraction gratings 403.

As shown in Figure 7, the three diffraction gratings 403 are configured on the tuning apparatus 409, and the three diffraction gratings 403 and the tuning apparatus 409 constitute one tuning component. The tuning apparatus 409 includes a driving apparatus and a rotation base for installing and supporting the diffraction gratings 403. The rotation base is connected with the driving apparatus, and the connection mode may be a common connection mode in the art, e.g. the rotation base may be connected with the driving apparatus through a rotation bearing. The three diffraction gratings 403 are configured on the rotation base of the tuning apparatus 409, and the rotation base may rotate on the rotation axis passing through the O point and being vertical to the paper surface. The driving apparatus is adapted to drive the rotation base through the rotation bearing to rotate according to a configured rotation rate, and thus change the location of each diffraction grating 403 configured on the rotation base, so that the location of a certain diffraction grating 403 in the multiple diffraction gratings 403 (three diffraction gratings 403 shown in Figure 7) may meet the continuous mod-hop-free tuning condition, thereby implementing the continuous mod-hop-free tuning of the output laser frequency of the laser.

In the GTECL, the tuning apparatus may drive the multiple diffraction gratings to rotate on the same rotation axis (i.e. the rotation axis passing through the O point and being vertical to the paper surface), the rotation radiuses of the diffraction gratings may be the same or different, and may be adjusted according to actual requirements, i.e. the locations of the three diffraction gratings on the tuning apparatus 409 (including the angle between the diffraction gratings, the relative location between each diffraction grating and the O point, and the distance from each diffraction grating to the O point) may be determined according to the formula (4.6) and actual applications. In addition, the driving apparatus may be a stepper motor or other apparatuses which can implement the driving.

As can be seen from Figure 7, the GTECL includes multiple diffraction gratings, and thus during the process that the tuning apparatus 409 rotates one circle around the rotation axis passing through the O point and being vertical to the paper surface, the optical component constituted by the gain medium and the collimating lens may perform the continuous mod-hop-free tuning of the needed laser frequency by using any diffraction grating configured on the tuning apparatus. Therefore, the GTECL may perform the continuous mod-hop-free tuning of the output laser light for many times through the multiple diffraction gratings, so as to decrease the period of performing the continuous mod-hop-free tuning and increase the sweeping rate and tuning speed of the GTECL.

In addition, the GTECL shown in Figure 7 may include one diffraction grating or multiple diffraction gratings. The number of the diffraction gratings may be predetermined according to actual requirements.

In the GTECL shown in Figure 7, it may be determined according to actual requirements whether the partial reflector 601 and/or the coupling apparatus 610 is configured, i.e. the partial reflector 601 and the coupling apparatus 610 are not indispensable components of the GTECL.

Figure 8 is a schematic diagram illustrating a GTECL according to a fourth embodiment of the present invention. As shown in Figure 8, in order to improve the usage of the diffraction gratings, one or multiple sets of optical components may be configured around the tuning apparatus 409 of the GTECL. Each set of optical components includes a gain medium 401 and a collimating lens 402, and may further include a partial reflector 601 and a coupling apparatus 610. When the tuning apparatus 409 rotates around the rotation axis passing through the O point and being vertical to the paper surface, each set of optical components may perform the continuous mod-hop-free tuning for the needed laser frequency by using any diffraction grating configured on the tuning apparatus 409 separately, so as to further improve the usage of the diffraction gratings, decrease the period of performing the continuous mod-hop-free tuning and increase the sweeping rate and tuning speed of the GTECL, thereby outputting multiplex laser light.

In the multiple sets of optical components configured in Figure 8, the optical components in different sets may select different gain mediums, different collimating lens, different diffraction gratings and different partial reflectors, to generate output laser light with different wavelength, thereby implementing unique output laser light with multiple wavelength and multiple light paths.

In the technical solution of the present invention, different types of GTECLs are provided. By using the GTECL, which is provided by the embodiments of the present invention, has a compact structure, and can implement multiple functional outputs, the continuous mod-hop-free tuning of laser frequency can be implemented, the manufacturing costs can be decreased, and the sweeping rate and tuning speed of the laser can be increased, so as to make the GTECL have a higher NIFF tuning capability, can be widely applied to the high-resolution laser metrology and spectroscopic sensors such as an atomic clock, a laser cooling/laser trap and an on-field biochemical analyzer.

In addition, since the GTECL provided in the technical solution of the present invention is the GTECL of the Littrow type, the resonant cavity of the laser has a compact structure and a simple shape, and can implement multiple functional outputs. In this way, the GTECL can be manufactured through a simplified manufacture process, with low costs and in batch production, and has a high stability and a compact structure.

The foregoing are only preferred embodiments of the present invention and are not for use in limiting the protection scope of the present invention. Any modification, equivalent replacement and improvement made within the spirit and principle of the present invention should be covered under the protection scope of the present invention.

**Claims**

1. A continuous mod-hop-free grating-tuned external cavity laser (GTECL), comprising at least one optical component constituted by a gain medium and a collimating lens, a tuning apparatus and at least one diffraction grating; wherein the gain medium is adapted to output a coherent light beam; the coherent light beam becomes parallel light after passing through the collimating lens; after the parallel light is diffracted by the diffraction grating, one part of diffraction light is directly taken as first output laser light, and the other part of diffraction light is returned to the gain medium along with an original incident light path, and is taken as second output laser light when exceeding an oscillation threshold of the laser through being oscillated and amplified in the gain medium;
   the diffraction grating is configured on the tuning apparatus; the tuning apparatus is adapted to drive the diffraction grating to rotate on a rotation axis located on a back surface of the diffraction grating; and the rotation axis is parallel with a diffraction surface of the diffraction grating and is vertical to an optical axis of the laser.

2. The GTECL of claim 1, wherein a location of the rotation axis is preconfigured to meet a condition that during a process of tuning output laser frequency of the laser, modulus of a longitudinal mode selected by a resonant cavity of the laser is a constant.

3. The GTECL of claim 1, wherein a rotation radius of the diffraction grating is a vertical distance from the ration axis to the diffraction surface of the diffraction grating.

4. The GTECL of claim 1, wherein the tuning apparatus is further adapted to change a location of the rotation axis in real time, or change a relative location between the rotation axis and the diffraction grating in real time.

5. The GTECL of claim 4, wherein the tuning apparatus comprises:

   a driving apparatus and a rotation base; the rotation base is connected with the driving apparatus;
   the rotation base is adapted to support or install the diffraction grating;
   the driving apparatus is adapted to drive the rotation base to make the diffraction grating rotate on the rotation axis, and change the location of the rotation axis in real time, or change the relative location between the rotation axis and the diffraction grating in real time.

6. The GTECL of claim 5, wherein the driving apparatus is a rotation motor, a stepper engine, or a micro electronic mechanic system.

7. The GTECL of claim 5, wherein the tuning apparatus further comprises a control apparatus and an encoder;
   the encoder is adapted to trace movement of the rotation base, and send a tracing result to the control apparatus;
   the control apparatus is adapted to selectively control movement of the rotation base according to the tracing result and selected wavelength of the output laser light, to perform continuous mod-hop-free tuning for output laser frequency of the laser.

8. The GTECL of claim 1, wherein the laser comprises multiple diffraction gratings;
   the multiple diffraction gratings are configured on the tuning apparatus; the tuning apparatus is adapted to drive the multiple diffraction gratings to rotate on the same rotation axis; the rotation axis is parallel with diffraction surfaces of the diffraction gratings and vertical to an optical axis of the laser;
   the optical component is adapted to perform continuous mod-hop-free tuning for output laser frequency by using any diffraction grating configured on the tuning apparatus.

9. The GTECL of claim 1, wherein the laser further comprises a partial reflector configured on a light path between the collimating lens and the diffraction grating;
   the partial reflector is adapted to generate third output laser light and fourth output laser light without a spectrum noise.

10. The GTECL of claim 9, wherein the partial reflector is a spectroscope, a space filter slice or a coupling fiber.

11. The GTECL of claims 1 or 9, wherein the laser further comprises a coupling apparatus;
    the coupling apparatus is adapted to couple at least one beam of the output laser light of the laser to a needed single mode or multimode fiber.

12. The GTECL of claim 1, wherein the laser further comprises one or more sets of optical components;

each set of the optical components is adapted to perform continuous mod-hop-free tuning for output laser frequency by using any one of the diffraction gratings configured on the tuning apparatus.

Figure 1

Figure 2

Figure 3

Figure 4

Figure 5

Figure 6

Figure 7

Figure 8

# INTERNATIONAL SEARCH REPORT

| International application No. |
| --- |
| PCT/CN2009/072560 |

**A. CLASSIFICATION OF SUBJECT MATTER**

See the extra sheet

According to International Patent Classification (IPC) or to both national classification and IPC

**B. FIELDS SEARCHED**

Minimum documentation searched (classification system followed by classification symbols)

IPC: H01S

Documentation searched other than minimum documentation to the extent that such documents are included in the fields searched

Electronic data base consulted during the international search (name of data base and, where practicable, search terms used)

WPI,EPODOC,CPRS,CNKI

grating? or grate? or raster??, rotat+ or turn+ or circum+ or round+, tun+ or adjust+

**C. DOCUMENTS CONSIDERED TO BE RELEVANT**

| Category* | Citation of document, with indication, where appropriate, of the relevant passages | Relevant to claim No. |
| --- | --- | --- |
| X | CN1113044A（UNIV QINGHUA），06 Dec. 1995（06.12.1995）pages 1-6, Figs. 1-3 | 1-8,12 |
| Y | | 9-11 |
| X | WO2007/103569A2（INPHASE TECHNOLOGIES INC et al.），13 Sep. 2007（13. 09. 2007）pages 6-17, Figs. 1, 6, 8-9 | 1-8,12 |
| Y | | 9-11 |
| Y | EP1139525A2（ANDO ELECTRIC CO LTD），04 Oct. 2001（04.10.2001）cols. 4-6, Fig. 2 | 9-11 |

☒ Further documents are listed in the continuation of Box C.     ☒ See patent family annex.

| | |
| --- | --- |
| \*    Special categories of cited documents: | "T"   later document published after the international filing date or priority date and not in conflict with the application but cited to understand the principle or theory underlying the invention |
| "A"   document defining the general state of the art which is not considered to be of particular relevance | |
| "E"   earlier application or patent but published on or after the international filing date | "X"   document of particular relevance; the claimed invention cannot be considered novel or cannot be considered to involve an inventive step when the document is taken alone |
| "L"   document which may throw doubts on priority claim (S) or which is cited to establish the publication date of another citation or other special reason (as specified) | "Y"   document of particular relevance; the claimed invention cannot be considered to involve an inventive step when the document is combined with one or more other such documents, such combination being obvious to a person skilled in the art |
| "O"   document referring to an oral disclosure, use, exhibition or other means | |
| "P"   document published prior to the international filing date but later than the priority date claimed | "&"document member of the same patent family |

| Date of the actual completion of the international search | Date of mailing of the international search report |
| --- | --- |
| 23 Mar. 2010 (23.03.2010) | **08 Apr. 2010 (08.04.2010)** |

| Name and mailing address of the ISA/CN | Authorized officer |
| --- | --- |
| The State Intellectual Property Office, the P.R.China 6 Xitucheng Rd., Jimen Bridge, Haidian District, Beijing, China 100088 Facsimile No. 86-10-62019451 | **WANG,Zhihua** Telephone No. (86-10)62085784 |

Form PCT/ISA /210 (second sheet) (July 2009)

**INTERNATIONAL SEARCH REPORT**

| International application No. |
| --- |
| PCT/CN2009/072560 |

C (Continuation). DOCUMENTS CONSIDERED TO BE RELEVANT

| Category* | Citation of document, with indication, where appropriate, of the relevant passages | Relevant to claim No. |
| --- | --- | --- |
| Y | WO01/71861A2（NEW FOCUS INC et al.），27 Sep. 2001（27.09.2001）pages 5-6, Fig. 2 | 9-11 |
| A | CN2687911Y（UNIV NANKAI），23 Mar. 2005（23.03.2005）the whole document | 1-12 |
| A | CN1502153A （MARCONI UK INTELLECTUAL PROPERTY LTD）， 02 Jun. 2004 （02.06.2004）the whole document | 1-12 |

Form PCT/ISA /210 (continuation of second sheet ) (July 2009)

## INTERNATIONAL SEARCH REPORT
### Information on patent family members

| | | International application No. |
| --- | --- | --- |
| | | PCT/CN2009/072560 |

| Patent Documents referred in the Report | Publication Date | Patent Family | Publication Date |
| --- | --- | --- | --- |
| CN1113044A | 06.12.1995 | CN1034146C | 26.02.1997 |
| WO2007103569A2 | 13.09.2007 | US2007223554A | 27.09.2007 |
| | | JP2009529786T | 20.08.2009 |
| EP1139525A2 | 04.10.2001 | CA2342552A | 30.09.2001 |
| | | US2001026563A | 04.10.2001 |
| | | JP2001284717A | 12.10.2001 |
| WO01/71861A2 | 27.09.2001 | AU7124301A | 03.10.2001 |
| | | US2001040910A | 15.11.2001 |
| | | US2001043637A | 22.11.2001 |
| | | US6606340B | 12.08.2003 |
| | | US2001050930A | 13.12.2001 |
| CN2687911Y | 23.03.2005 | None | |
| CN1502153A | 02.06.2004 | WO02080319A | 10.10.2002 |
| | | CA2437110A | 10.10.2002 |
| | | EP1374355AB | 02.01.2004 |
| | | CN1237674C | 18.01.2006 |
| | | US2004151214A | 05.08.2004 |
| | | US7116481B | 03.10.2006 |
| | | AT306729T | 15.10.2005 |
| | | DE60206610T | 11.05.2006 |

Form PCT/ISA /210 (patent family annex) (July 2009)

19

## INTERNATIONAL SEARCH REPORT

| International application No. |
|---|
| PCT/CN2009/072560 |

CLASSIFICATION OF SUBJECT MATTER:
H01S5/14(2006.01) i
H01S5/06(2006.01) i

Form PCT/ISA /210 (extra sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6731661 B, Trutna Jr.
- US 5319668 A, Luecke
- US 5867512 A, Sacher
- US 5771252 A, Lang
- US 5802085 A
- US 6606340 B
- US 6608847 B
- US 6788726 B
- US 6940879 B, Zhang
- US 7388890 B, Le

### Non-patent literature cited in the description

- **Carl E. Wieman ; Leo Hollberg.** 'using Diode Lasers for Atomic Physics. *Review of Scientific Instruments,* January 1991, vol. 62, 1-19